# EUROPEAN PATENT APPLICATION

(11) **EP 4 576 993 A1**
(43) Date of publication of application: **25.06.2025**
(21) Application number: 24216711.2
(22) Date of filing: 02.12.2024
(51) Int. Cl.: H10D 30/60, H10D 30/66, H10D 62/13, H10D 62/17

(54) **POWER SEMICONDUCTOR DEVICE AND POWER CONVERTER INCLUDING THE SAME**

(30) Priority: 19.12.2023 KR 20230186367; 17.06.2024 KR 20240077977
(71) Applicant: LX Semicon Co., Ltd., Daejeon 34027 (KR)
(72) Inventor: LEE, Hojung, 34027 Daejeon (KR)
(74) Representative: Goddar, Heinz J.

(57) **Abstract**

A power semiconductor device according to an embodiment includes a substrate, an epi layer of a first conductivity type disposed on the substrate, a JFET region disposed on the epi layer of the first conductivity type, a plurality of second wells of a second conductivity type disposed spaced apart from each other in the JFET region, a source region of the first conductivity type disposed on the second wells of the second conductivity type, a gate insulating layer disposed on the source region of the first conductivity type, a gate disposed on the gate insulating layer, and a first well of the second conductivity type disposed under the gate insulating layer.

## Description

### BACKGROUND OF THE DISCLOSURE

### 1. Field of the Disclosure

The embodiment relates to a power semiconductor device and a power converter including the same.

### 2. Background of the Related Art

Power semiconductor is one of the key elements that determines the efficiency, speed, durability, and reliability of power electronic systems.

With the recent development of the power electronics industry, the previously used silicon (Si) power semiconductors have reached their physical limits, research is being actively conducted on WBG (wide bandgap) power semiconductors such as silicon carbide (SiC) and gallium nitride (GaN) power semiconductor to replace the Si power semiconductor.

WBG power semiconductor devices have a band gap energy that is approximately three times than that of Si power semiconductor devices, due to this, it has the characteristics of low intrinsic carrier concentration, high breakdown electric field (about 4 to 20 times), high thermal conductivity (about 3 to 13 times), and large electron saturation rate (about 2 to 2.5 times) comparing the Si power semiconductor.

Since these characteristics enable operation in high temperature and high voltage environments, the WBG power semiconductor devices have high switching speed and low switching loss. Among these, gallium nitride (GaN) power semiconductor devices may be used in low-voltage systems, and silicon carbide (SiC) power semiconductor devices may be suitable for high-voltage systems.

SiC MOSFET power semiconductors in the prior art generally have a vertical diffused structure and are referred to as VDMOSFETs, and also may be referred to simply as double-diffused structure DMOSFETs. Additionally, SiC MOSFETs may be classified into Planar MOSFETs and Trench MOSFETs depending on the direction of the channel.

On the other hand, in MOSFET, it is difficult to control a channel thickness or a doping concentration of the channel, etc. and thus, there is a problem in that leakage current occurs in the channel such that the leakage current can lead to problems of reducing electrical performance or and reliability of the device.

### SUMMARY OF THE DISCLOSURE

One of the technical objects of the embodiment is to control the thickness or the width of the channel in the SiC MOSFET.

In addition, one of the technical objects of the embodiment is to prevent leakage current in the channel in the SiC MOSFET.

In addition, one of the technical objects of the embodiment is to improve the electrical performance of the SiC MOSFET.

The technical objects of the embodiment are not limited to those described in this item, and include those that can be understood through the description of the invention.

A power semiconductor device according to the embodiment may include a substrate (110), an epi layer of a first conductivity type (115) disposed on the substrate (110), a JFET region (137) disposed on the epi layer of the first conductivity type (115), a plurality of second wells of the second conductivity type (135) disposed spaced apart from each other in the JFET region (137), a source region of the first conductivity type (140) disposed on the second wells of the second conductivity type (135), a gate insulating layer (150) disposed on the source region of the first conductivity type (140), a gate (155) disposed on the gate insulating layer (150), and a first well of the second conductivity type (130) disposed under the gate insulating layer.

In addition, in the embodiment, the first well of the second conductivity type (130) may be disposed spaced apart from the second wells of the second conductivity type (135).

In addition, in the embodiment, the JFET region (137) may be disposed between the first well of the second conductivity type (130) and the second wells of the second conductivity type (135).

In addition, in the embodiment, a horizontal width of the gate insulating layer (150) may be greater than that of the first well of the second conductivity type (130).

In addition, in the embodiment, the source region of the first conductivity type (140) may be in contact with the JFET region (137).

In addition, in the embodiment, a top surface of the first well of the second conductivity type (130) may be in contact with the gate insulating layer (150), and the side surface of the first well of the second conductivity type (130) may be in contact with the source region of the first conductivity type (140).

In addition, in the embodiment, a thickness of the first well of the second conductivity type (130) may be thinner than that of the source region of the first conductivity type (140).

In addition, in the embodiment, a top surface of the first well of the second conductivity type (130) may be the same as that of the source region of the first conductivity type (140).

In addition, according to another embodiment, a power semiconductor device may include a substrate (110), an epi layer of a first conductivity type (115) disposed on the substrate (110), a CSL region (138) disposed on the epi layer of the first conductivity type (115), a plurality of second wells of a second conductivity type (135) disposed spaced apart from each other in the CSL region (138), a source region of the first conductivity type (140) disposed on the second wells of the second conductivity type (135), a gate (155) disposed between the plurality of second wells of the second conductivity type (135), a gate insulating layer (150) to surround the gate, and a first well of the second conductivity type (130) disposed on a side surface of the gate insulating layer (150).

In addition, in the embodiment, the first well of the second conductivity type (130) may be spaced apart from the second wells of the second conductivity type (135).

In addition, in the embodiment, a side surface of the gate insulating layer (150) may be in contact with the source region of the first conductivity type (140) and the first well of the second conductivity type (130).

In addition, in the embodiment, a top surface of the first well of the second conductivity type (130) may be in contact with the source region of the first conductivity type (140), and the CSL region (138) may be disposed between the first well of the second conductivity type (130) and the second wells of the second conductivity type (135).

### EFFECTS OF THE DISCLOSURE

The power semiconductor device according to the embodiment has a technical effect of controlling the thickness or the width of the channel.

For example, the embodiment can control the thickness or width of the channel by controlling the thickness or the width of the first well of the second conductivity type (130) and the second wells of the second conductivity type (135).

In addition, the embodiment has a technical effect of improving the electrical performance of the SiC MOFET.

For example, the embodiment can improve the electrical performance by reducing the on-state resistance (Ron) by forming the width of the channel wide.

In addition, the embodiment has a technical effect of preventing the leakage current of the channel.

For example, the embodiment forms a PN junction at the upper and lower portions of the channel, and when in the off state, a depletion is formed at the upper and lower portions to prevent the leakage current of the channel through channel blocking.

The technical effect of the embodiment is not limited to what is described in this item, and includes what can be understood through the description of the invention.

### BRIEF DESCRIPTION OF THE DRAWINGS

Fig. 1 is a view showing an example of a power converter (1000) according to an embodiment.
Fig. 2 is a cross-sectional view of a power semiconductor device (100) according to an embodiment.
Fig. 3 is a cross-sectional view of a power semiconductor device according to an embodiment.
Figs. 4A to 4E are manufacturing process views of a power semiconductor device according to an embodiment.
Figs. 5A and 5B are drawings showing the channel region (Ch) of Fig. 3 in detail.
Fig. 6 is a graph showing implantation concentration according to depth in the BB' line of Fig. 5A.
Fig. 7 is a cross-sectional view of a power semiconductor device according to a second embodiment.

### DETAILED DESCRIPTION OF THE DISCLOSURE

Hereinafter, the embodiments disclosed in this specification will be described in detail with reference to the attached drawings. The suffixes 'module' and 'part' used for elements in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist in between.

In the specification or claims, the meaning of "an element A includes at least one of a, b, and/or c" may include ① when the element A includes a, ② when the element A includes b, ③ when the element A includes c, ④ when the element A includes a and b, ⑤ when the element A includes b and c, ⑥ when the element A includes a and c, and ⑦ when the element A includes all of a, b, and c.

The singular expression includes the plural expression as well as the singular expression, unless the context clearly indicates otherwise. For example, the meaning of "element A includes one structure" may include the meaning of "element A includes one or more structures."

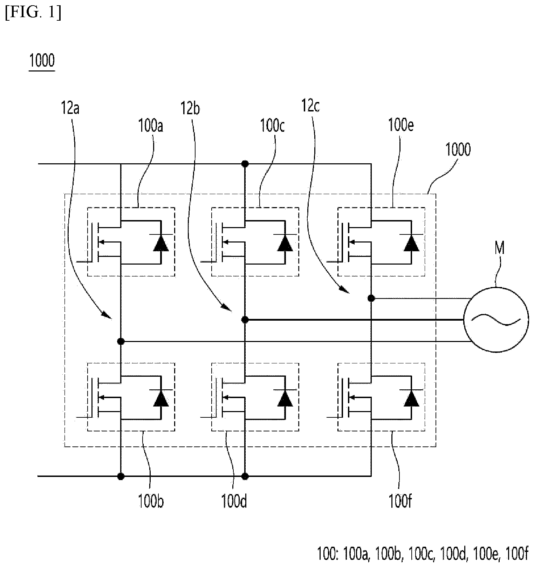

FIG. 1 is an example view of a power converter (1000) according to an embodiment.

The power converter (1000) according to the embodiment can receive DC power from a battery or a fuel cell, convert it into AC power, and supply AC power to a predetermined load. For example, the power converter (1000) according to the embodiment can include an inverter, and can receive DC power from a battery, convert it into three-phase AC power, and supply it to a motor (M), and the motor (M) can provide power to an electric vehicle, a fuel cell vehicle, etc.

The power converter (1000) according to an embodiment may include a power semiconductor device (100). The power semiconductor device (100) may be a MOSFET (Metal Oxide Semiconductor Field Effect Transistor), but is not limited thereto, and may include an IGBT (Insulated Gate Bipolar Transistor).

For example, the power converter (1000) may include a plurality of power semiconductor devices (100a, 100b, 100c, 100d, 100e, 100f) and may include a plurality of diodes (not shown). Each of the plurality of diodes may be embedded in the power semiconductor devices (100a, 100b, 100c, 100d, 100e, 100f) in the form of an internal diode, but is not limited thereto, and may be disposed separately.

The embodiment may convert DC power into AC power through on-off control for a plurality of power semiconductor devices (100a to 100f). For example, the power converter (1000) according to the embodiment can supply positive power to the motor (M) by turning on the first power semiconductor device (100a) and turning off the second power semiconductor device (100b) in the first time period of one cycle, and supply negative power to the motor (M) by turning off the first power semiconductor device (100a) and turning on the second power semiconductor device (100b) in the second time period of one cycle.

In the embodiment, a group of power semiconductor devices arranged in series on a high-voltage line and a low-voltage line of the input side can be called an arm. For example, the first power semiconductor device (100a) and the second power semiconductor device (100b) may form a first arm, the third power semiconductor device (100c) and the fourth power semiconductor device (100d) may form a second arm, and the fifth power semiconductor device (100e) and the sixth power semiconductor device (100t) may form a third arm.

In the arm, the upper power semiconductor device and the lower power semiconductor device may be controlled not to be turned on at the same time. For example, in the first arm, the first power semiconductor device (100a) and the second power semiconductor device (100b) may not be turned on at the same time but may be turned on and off alternately.

Each power semiconductor device (100a to 100f) may be supplied with high power while in an off state. For example, when the first power semiconductor device (100a) is turned on and the second power semiconductor device (100b) is turned off, the input voltage can be applied as is to the second power semiconductor device (100b). The voltage input to the second power semiconductor device (100b) can be a relatively high voltage, and the withstand voltage of each power semiconductor device (100a to 100f) can be designed to be high so as to withstand this high voltage.

Each power semiconductor device (100a to 100f) can conduct a high current in the turned-on state. The motor (M) is driven by a relatively high current, and this high current can be supplied to the motor (M) through the power semiconductor that is turned on.

The high voltage applied to each power semiconductor device (100a to 100f) can cause a high switching loss. The high current that conducts the power semiconductor device (100a~100f) may cause high conduction loss. In order to release the heat generated by this loss, the power semiconductor device (100a~100f) may be packaged as a power semiconductor module including a heat dissipation means.

The power semiconductor device (100) of the embodiment may be a silicon carbide (SiC) power semiconductor device, and may be capable of operating in a high temperature and high voltage environment and may have a high switching speed and low switching loss.

Meanwhile, the power converter (1000) according to the embodiment may include a plurality of power semiconductor modules.

For example, the plurality of power semiconductor devices (100a~100f) illustrated in FIG. 1 may be packaged as one power semiconductor module, or the power semiconductor devices constituting each arm may be packaged as one power semiconductor module.

For example, the first power semiconductor device (100a), the second power semiconductor device (100b), the third power semiconductor device (100c), the fourth power semiconductor device (100d), the fifth power semiconductor device (100e), and the sixth power semiconductor device (100f) illustrated in FIG. 1 may be packaged as one power semiconductor module.

In addition, there may be additional power semiconductor devices arranged in parallel with each power semiconductor device (100a to 100f) to increase current capacity. In this case, the number of power semiconductor devices included in the power semiconductor module may be more than six.

The power converter (1000) according to the embodiment may also include a power semiconductor device in the form of a diode in addition to the power semiconductor devices in the form of a transistor (100a to 100f). For example, a first diode (not shown) may be disposed in parallel with the first power semiconductor device (100a), and a second diode (not shown) may be disposed in parallel with the second power semiconductor device (100b). In addition, these diodes may also be packaged together in one power semiconductor module. In addition, the diodes may be disposed in the form of internal diodes in each power semiconductor device.

Next, the power semiconductor devices constituting each arm may be packaged as one power semiconductor module.

For example, the first power semiconductor device (100a) and the second power semiconductor device (100b) constituting the first arm may be packaged as a first power semiconductor module, the third power semiconductor device (100c) and the fourth power semiconductor device (100d) constituting the second arm may be packaged as a second power semiconductor module, and the fifth power semiconductor device (100e) and the sixth power semiconductor device (100f) constituting the third arm may be packaged as a third power semiconductor module.

In addition, in order to increase the current capacity, there may be an additional power semiconductor device arranged in parallel with each power semiconductor device (100a to 100f), and in this case, the number of power semiconductor devices included in each power semiconductor module may be more than two. In addition to the transistor-type power semiconductor devices (100a to 100f), each arm may also include a diode-type power semiconductor device (not shown), and these diodes may also be packaged together in a single power semiconductor module. In addition, the diode may be disposed in the form of an internal diode in each power semiconductor device.

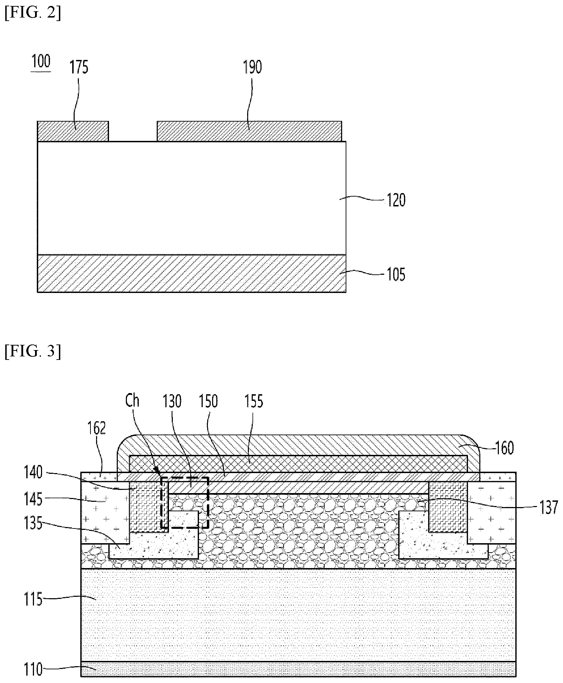

Next, FIG. 2 is a cross-sectional view of one of the power semiconductor devices (100) according to the embodiment.

The power semiconductor device (100) according to the embodiment may include a source electrode (190), a gate electrode (175) arranged on an upper side of a predetermined semiconductor epi layer (120), and a drain electrode (105) arranged on a lower side of the semiconductor epi layer (120).

In the form of a MOSFET, the source electrode (190) or the gate electrode (175) may include an Al or Al alloy, and the drain electrode (105) may include a Ti/Ni/Ag metal including a Ti layer, a Ni layer, and an Ag layer, or NiV/Ag, V(vanadium)/Ni/Ag, etc., but is not limited thereto.

Next, FIG. 3 is a cross-sectional view of a power semiconductor device according to an embodiment. Referring to FIG. 3, the power semiconductor device according to the embodiment may include a substrate (110), an epi layer of a first conductivity type (115), a first well of a second conductivity type (130), a second wells of the second conductivity type (135), a source region of the first conductivity type (140), a JFET region (137), a gate insulating layer (150), and a source electrode (162).

In detail, in the embodiment, a drain electrode (not shown) may be disposed under the substrate (110). In addition, the epi layer of the first conductivity type (115) may be disposed on the substrate (110). The epi layer of the first conductivity type (115) may be a N-type drift region, but is not limited thereto. The substrate (110) and the epi layer of the first conductivity type (115) may include a 4H-SiC material, but is not limited thereto.

In addition, a JFET region (137) may be disposed on the epi layer of the first conductivity type (115). A plurality of second wells of the second conductivity type (135) may be disposed to be spaced apart from each other in the JFET region (137). A source region of the first conductivity type (140) and a contact region of the second conductivity type (145) may be disposed on the second wells of the second conductivity type (135). The second wells of the second conductivity type (135) and the source region of the first conductivity type (140) may partially overlap. In addition, the second wells of the second conductivity type (135) and the contact region of the second conductivity type (145) may partially overlap.

In addition, the first well of the second conductivity type (130) may be disposed on the second wells of the second conductivity type (135). The second wells of the second conductivity type (135) may be spaced apart from the first well of the second conductivity type (130). The second wells of the second conductivity type (135) may have a JFET region (137) positioned between the first well of the second conductivity type (130).

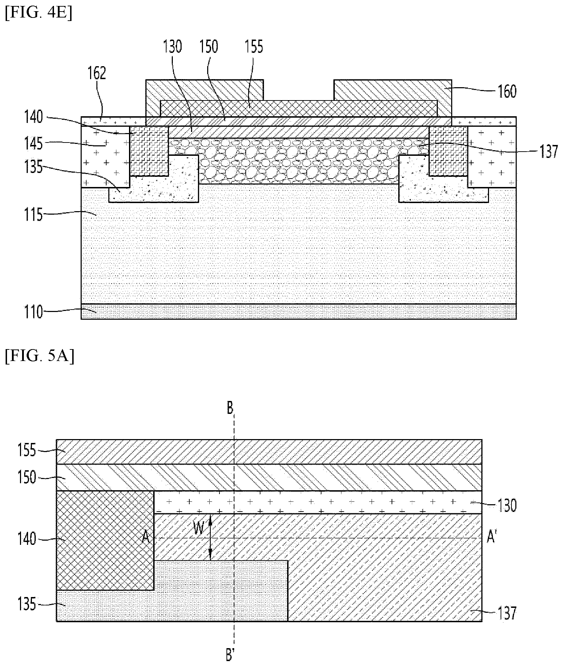

In addition, a top surface of the first well of the second conductivity type (130) may be the same as a top surface of the source region of the first conductivity type (140), but is not limited thereto. In addition, a gate insulating layer (150) may be disposed on the first well of the second conductivity type (130). The horizontal width of the gate insulating layer (150) may be greater than the horizontal width of the first well of the second conductivity type (130). The gate insulating layer (150) may be disposed to cover the first well of the second conductivity type (130) and the source region of the first conductivity type (140). In addition, the gate insulating layer (150) may cover a part of the contact region of the second conductivity type (145). In addition, a source electrode (162) may be disposed on a side of the gate insulating layer (150) to be in contact with the contact region of the second conductivity type (145). The source electrode (162) may be electrically connected to the first source region (140) of the first conductivity type (see FIG. 4E).

In addition, a gate (155) may be disposed on the gate insulating layer (150). The horizontal width of the gate (155) may be smaller than the horizontal width of the gate insulating layer (150). In addition, an interlayer insulating layer (160) may be disposed to cover the gate (155). In addition, a source electrode (162) may be disposed on the contact region of the second conductivity type (145).

Meanwhile, one of the technical objects of the embodiment is to increase channel mobility in a MOSFET. Meanwhile, in the MOSFET structure studied internally, it is difficult to control the depth, a thickness, a doping concentration, etc. of the channel, and thus, a problem of leakage current occurring in the channel has been studied.

To solve the above problem, a first well of the second conductivity type (130) may be disposed under the gate insulating layer (150) in the embodiment. In detail, the source region of the first conductivity type (140) is in contact with the JFET region (137), and a channel can be formed through the JFET region (137) under the gate insulating layer (150) between the first well of the second conductivity type (130) and the second wells of the second conductivity type (135).

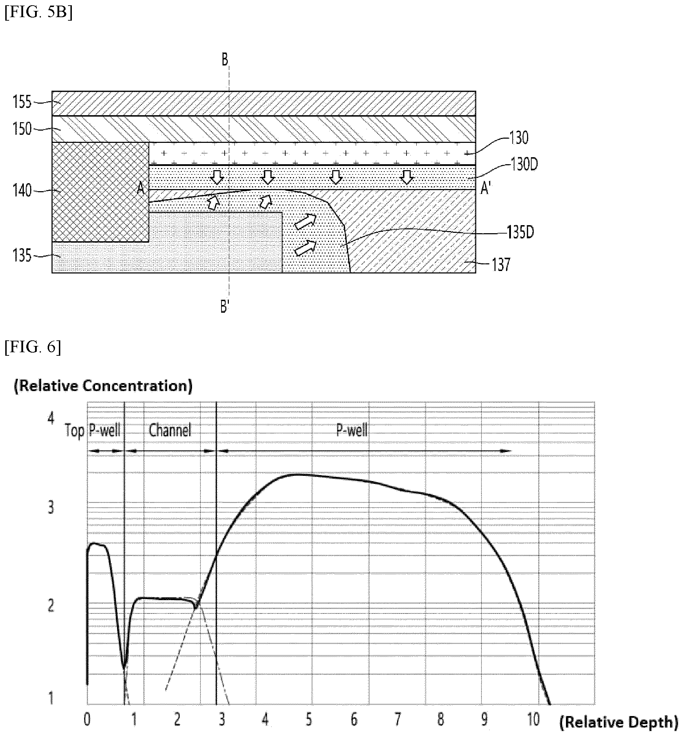

FIGS. 5A and 5B are drawings showing the left channel region (Ch) of FIG. 3 in detail.

For example, FIG. 5A is a detailed view of the channel region (Ch) in the On state of the power semiconductor device of the embodiment, and FIG. 5B is a detailed view of the channel region (Ch) in the Off state of the power semiconductor device of the embodiment.

Referring to FIG. 5B, in the OFF state of the MOSFET, a depletion can occur at the upper and lower portions of the channel. In detail, the first well of the second conductivity type (130) located at the top may cause a depletion in the downward direction (130D), and the second wells of the second conductivity type (135) located at the bottom may cause a depletion in the upward direction(135D). Accordingly, the embodiment has a special technical effect that can effectively prevent a leakage current of the channel by causing a depletion at the upper and lower portions of the channel in the off state and thereby causing channel blocking in the off state.

In addition, the embodiment has a technical effect that can control the width (W) of the channel by controlling the thickness of the first well of the second conductivity type (130) or the thickness of the second wells of the second conductivity type (135).

For example, a vertical distance between the first well of the second conductivity type (130) and the second wells of the second conductivity type (135) can be controlled to be greater than the thickness of the first well of the second conductivity type (130).

Accordingly, the embodiment can effectively prevent leakage current of the channel by causing depletion (130D) in the upper first well of the second conductivity type, and depletion (135D) in the lower second wells of the second conductivity type, thereby forming the width (W) of the channel wider than before, thereby reducing the on-state resistance (Ron), and thus improving the electrical performance.

Although a SiC planar MOSFET is illustrated in Fig. 3, the technical features of the present invention can be applied to Trench MOSFET, SJ-MOSFET, IGBT, Diode, etc.

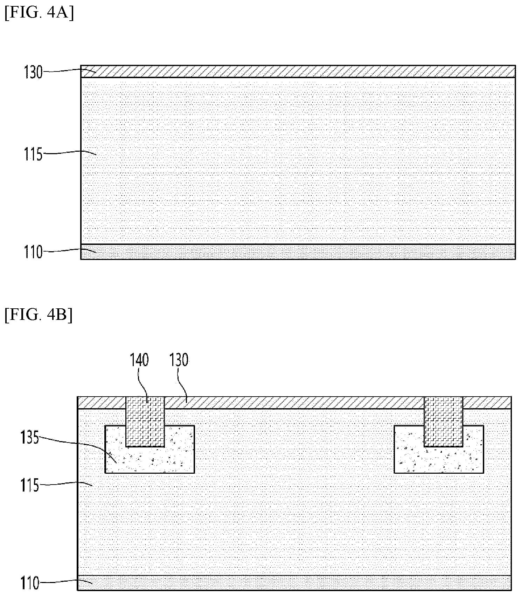

Hereinafter, referring to FIGS. 4A to 4E, the manufacturing process of the power semiconductor device according to the embodiment will be described in more detail while describing the technical features of the embodiment.

First, referring to FIG. 4A, an epi layer of a first conductivity type (115) can be formed on a substrate (110).

The substrate (110) and the epi layer of the first conductivity type (115) may include the SiC (Silicon Carbide), but are not limited thereto.

For example, the substrate (110) and the epi layer of the first conductivity type (115) may include a 4H-SiC material, but are not limited thereto. For example, the substrate (110) and the epi layer of the first conductivity type (115) may include 3C-SiC or 6H-SiC. In addition, the first conductivity type may be N-type, and the second conductivity type may be P-type, but is not limited thereto. The epi layer of the first conductivity type (115) may be a N-type drift region, but is not limited thereto. In addition, a drain electrode (not shown) may be disposed under the substrate (110).

For example, the epi layer (115) of the first conductivity type may include a plurality of layers having different concentrations, and may have a current spreading layer (CSL) function. For example, the epi layer (115) of the first conductivity type may include a first conductivity type buffer layer (not shown) and a first conductivity type drift layer (not shown).

In addition, a first well of a second conductivity type (130) may be formed on the epi layer of the first conductivity type (115). The first well of the second conductivity type (130) may be formed through an implant process, but is not limited thereto. For example, the first well of the second conductivity type (130) may be ion-implanted with a P-type dopant at a concentration of about 1×10¹⁶cm⁻³ to about 2×10¹⁸ cm⁻³. For example, Al or boron may be implanted, but is not limited thereto.

Next, referring to FIG. 4B, a second wells of a second conductivity type (135) may be formed under the first well of the second conductivity type (130) through an implant process. The second wells of the second conductivity type (135) may be disposed spaced apart from the lower surface of the first well of the second conductivity type (130).

For example, the second well of the second conductivity type (135) may be ion-implanted with a P-type dopant at a concentration of about 1×10¹⁷cm⁻³ to about 2×10¹⁹ cm⁻³. For example, Al or boron may be implanted, but is not limited thereto.

In addition, a source region of the first conductivity type (140) may be formed on the second wells of the second conductivity type (135) through an implant process. The source region of the first conductivity type (140) may be formed by penetrating the first well of the second conductivity type (130). In addition, the source region of the first conductivity type (140) may be formed to penetrate a portion of the second wells of the second conductivity type (135). The horizontal width of the source region of the first conductivity type (140) may be smaller than the horizontal width of the second wells of the second conductivity type (135).

For example, the first source region of the first conductivity type (140) can be formed by ion-implanting a N-type dopant such as nitrogen or phosphorus at a concentration of about 1×10¹⁹ cm⁻³ to about 7×10¹⁹ cm⁻³ in a self-aligned manner.

In the embodiment, the first well of the second conductivity type (130) that functions as a top P-Well can be in contact with the source region of the first conductivity type (140), and thus the first well of the second conductivity type (130) can be in electrical contact with the source electrode. Accordingly, the first well of the second conductivity type (130) can function to maintain the zero potential of the second well of the second conductivity type (135).

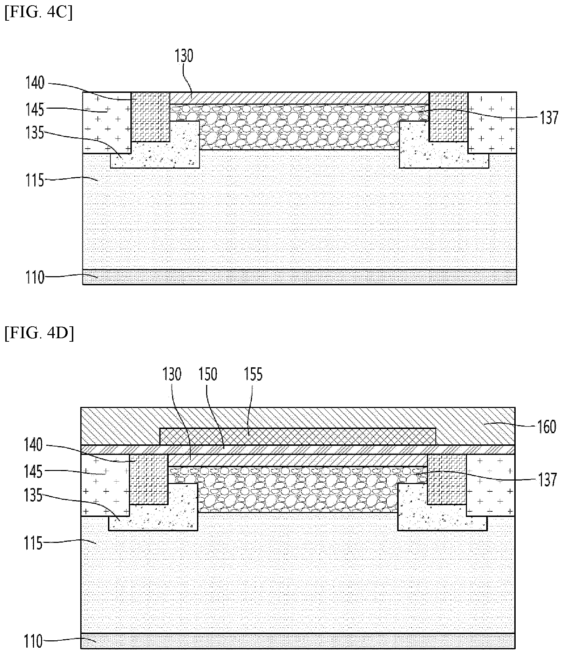

Next, referring to FIG. 4C, a contact region of the second conductivity type (145) can be formed on the side of the source region of the first conductivity type (140). The lower surface of the contact region of the second conductivity type (145) may be formed lower than the lower surface of the source region of the first conductivity type (140) and may be in contact with the second well of the second conductivity type (135). In addition, the upper surface of the contact region of the second conductivity type (145) may have the same height as the upper surface of the source region of the first conductivity type (140). The contact region of the second conductivity type (145) may then be in contact with the source electrode. In addition, the contact region of the second conductivity type (145) may have the function of maintaining the zero potential of the second well of the second conductivity type (135) and may have a body diode function.

In addition, a JFET region (137) may be formed by ion implantation as the first conductivity type under the first well of the second conductivity type (130). The JFET region (137) may be a region between the plurality of second wells of the second conductivity type (135). The JFET region (137) may be in contact with a side surface of the source region of the first conductivity type (140). In addition, the JFET region (137) may be in contact with the first well of the second conductivity type (130) and the second wells of the second conductivity type (135). The JFET region (137) may be disposed between the first well of the second conductivity type (130) and the second wells of the second conductivity type (135). Then, a channel may be formed between the lower surface of the first well of the second conductivity type (130) and the upper surface of the second wells of the second conductivity type (135) (see FIG. 3). In addition, the lower surface of the JFET region (137) may be positioned higher than the lower surface of the second wells of the second conductivity type (135).

Next, referring to FIG. 4D, a gate insulating layer (150) may be disposed on the first well of the second conductivity type (130). The gate insulating layer (150) may be a thermal oxide film or a deposition oxide film, but is not limited thereto. The gate insulating layer (150) may be formed to cover the first well of the second conductivity type (130), the source region of the first conductivity type (140), and the contact region of the second conductivity type (145). In addition, the first well of the second conductivity type (130) may be disposed between the gate insulating layer (150) and the JFET region (137).

In addition, a gate (155) may be formed on the gate insulating layer (150). The horizontal width of the gate (155) may be greater than the horizontal width of the first well of the second conductivity type (130). The gate insulating layer (150) may be disposed between the gate (155) and the first well of the second conductivity type (130).

In addition, an interlayer insulating layer (160) may be disposed to cover the gate (155).

Next, referring to FIG. 4E, a part of the interlayer insulating layer (160) may be removed. In addition, a part of the gate insulating layer (150) may be removed to expose the source region of the first conductivity type (140) and the contact region of the second conductivity type (145). At this time, a source electrode (162) may be formed in the area where the gate insulating layer (150) is removed. The source electrode (162) may be in contact with the source region of the first conductivity type (140) and the contact region of the second conductivity type (145).

In addition, a part of the interlayer insulating layer (160) may be removed to expose a part of the gate (155). Thereafter, a gate pad electrode (not shown) may be formed on the exposed gate (155). In addition, a source pad electrode (not shown) may be formed on the source electrode (162). In addition, a first passivation layer (not shown) may be formed to cover a part of the gate pad electrode and the source pad electrode. In addition, a second passivation layer (not shown) may be formed to cover the remaining part of the gate pad electrode and the source pad electrode and cover the first passivation layer. A part of the gate pad electrode and the source pad electrode may be exposed.

In addition, an upper pad may be formed on the exposed gate pad electrode and the source pad electrode. In addition, a drain electrode (not shown), which is a bottom electrode, may be formed under the substrate (110), and a bottom pad electrode may be formed under the bottom electrode.

FIG. 5A is an enlarged view of the left channel region (Ch) in the power semiconductor device according to the embodiment of FIG. 3. Referring to FIG. 5A, a channel region (Ch) may be formed between the second wells of the second conductivity type (135) and the first well of the second conductivity type (130). A current path may be formed through the source electrode (162) to pass through the source region of the first conductivity type (140) and the channel and JFET region (137). In the embodiment, the width (W) of the channel may be a gap between the first well of the second conductivity type (130) and the second wells of the second conductivity type (135).

Meanwhile, in the embodiment, since the JFET region (137) in contact with the source region of the first conductivity type (140) is disposed between the first well of the second conductivity type (130) and the second wells of the second conductivity type (135) at the upper and lower portions, respectively, the MOSFET in the off state may have a PN junction formed at the upper and lower portions, and thus depletion may occur at each portion.

For example, referring to Fig. 5B, in the MOSFET in the off state, the first well of the second conductivity type (130) located at the upper portion may have a depletion (130D) in the downward direction, and the second wells of the second conductivity type (135) located at the lower portion may have a depletion (135D) in the upward direction. Accordingly, in the embodiment, the depletions may occur at the upper and lower portions of the channel in the off state, and a channel blocking may occur in the off state, thereby blocking the leakage current of the channel.

Accordingly, according to the embodiment, the depletion regions can meet each other at the AA' line, which is approximately a middle line of the channel. Therefore, the embodiment has a special technical effect in that the channel blocking can be performed in the off state because the depletions are formed in the channel direction at the gate insulating layer (150), thereby effectively preventing the leakage current of the channel.

In addition, the embodiment has a technical effect that the width (W) of the channel can be controlled by controlling the thickness of the first well of the second conductivity type (130) or the thickness of the second wells of the second conductivity type (135).

For example, a vertical distance between the first well of the second conductivity type (130) and the second wells of the second conductivity type (135) can be controlled to be greater than the thickness of the first well of the second conductivity type (130).

Accordingly, the embodiment can effectively prevent the leakage current of the channel by causing the depletion in the upper first well of the second conductivity type (130) in the downward direction (130D) and the depletion in the lower second wells of the second conductivity type (135) in the upward direction (135D), so that the width (W) of the channel can be formed wider than before. Therefore, by reducing the on-state resistance (Ron), there is a technical effect of improving the electrical performance.

Next, Fig. 6 is a graph showing the implantation concentration gradient at the BB' line in Fig. 5A.

Referring to Fig. 6, the implantation concentration can decrease rapidly at the boundary between the first well of the second conductivity type (130) (Top P-well) and the JFET region (137), which is the point where the P-type and the N-type are changed. In the Y-axis of Fig. 6, the first well of the second conductivity type (130) may be a P-type concentration, and the JFET region (137) may be a N-type concentration.

Meanwhile, a channel region is formed between the first well of the second conductivity type (130) and the second wells of the second conductivity type (135), and the concentration in the channel region may be constant. In addition, the implantation concentration may rapidly increase at the boundary between the channel region and the second wells of the second conductivity type (135).

In the Y-axis of Fig. 6, the second wells of the second conductivity type (135) may be a P-type concentration.

In an embodiment, the vertical distance between the first well of the second conductivity type (130) and the second wells of the second conductivity type (135) may be controlled to be greater than the thickness of the first well of the second conductivity type (130).

Accordingly, in the embodiment, the distance between the first well of the second conductivity type (130) and the second wells of the second conductivity type (135) may be the width (W) of the channel region, and the width (W) of the channel region may be thicker than the thickness of the first well of the second conductivity type (130), which is the upper P-well.

For example, the width (W) of the channel region may correspond to a thickness of 1.5 to 3 times thickness of the first well of the second conductivity type (130), which is the upper P-well. In addition, preferably, the width (W) of the channel region may have a thickness of 2.0 to 2.5 times thickness of the first well of the second conductivity type (130), which is the upper P-well, but is not limited thereto.

According to an embodiment, the width (W) of the channel region may be controlled to be thicker than the thickness of the first well of the second conductivity type (130), which is the upper P-well, so that the on-state resistance (Ron) can be reduced, and thus, there is a special technical effect of improving the electrical performance.

In addition, in an embodiment, the concentration of the first well of the second conductivity type (130) may be lower than the concentration of the second wells of the second conductivity type (135). For example, the first well of the second conductivity type (130) may be ion-implanted with a P-type dopant at a concentration of about 1×10¹⁶ cm⁻³ to about 2×10¹⁸ cm⁻³.

In addition, the second well of the second conductivity type (135) may be ion-implanted with a P-type dopant at a concentration of about 1×10¹⁷ cm⁻³ to about 2×10¹⁹ cm⁻³, but is not limited thereto.

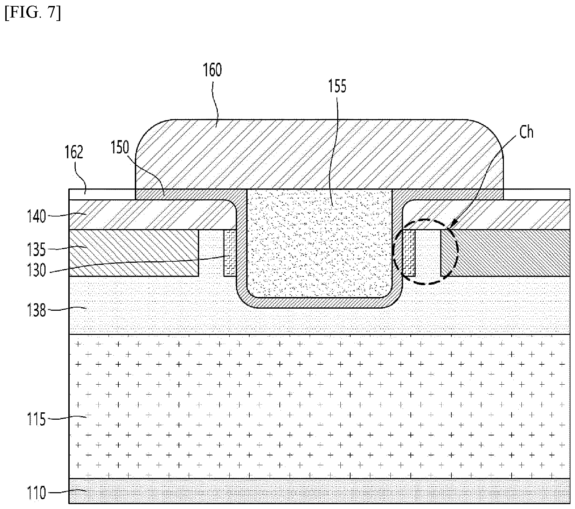

Next, FIG. 7 is a cross-sectional view of a power semiconductor device according to a second embodiment. The power semiconductor device of the second embodiment may be a trench MOSFET. Referring to FIG. 7, an epi layer of a first conductivity type (115) may be disposed on a substrate (110). In addition, a CSL (current spreading layer) region (138) may be disposed on the epi layer of the first conductivity type (115). In addition, a plurality of second wells of a second conductivity type (135) may be disposed spaced apart from each other on the CSL region (138). The CSL region (138) may be grown by an epitaxy process by being doped with a first conductivity type on the epi layer of the first conductivity type (115), but is not limited thereto.

In addition, a source region of the first conductivity type (140) may be disposed on the second wells of the second conductivity type (135). A trench-shaped gate (155) may be disposed between the plurality of second wells of the second conductivity type (135). In addition, a gate insulating layer (150) may be disposed to surround the gate (155).

Meanwhile, the second embodiment may further include a first well of the second conductivity type (130) disposed on a side of the gate insulating layer (150). The side surface of the gate insulating layer (150) may be in contact with the source region of the first conductivity type (140) and the first well of the second conductivity type (130).

The first well of the second conductivity type (130) may be positioned below the source region of the first conductivity type (140). In addition, the first well of the second conductivity type (130) may be spaced apart from the second wells of the second conductivity type (135) by a predetermined distance.

A CSL region (138) may be disposed between the first well of the second conductivity type (130) and the second wells of the second conductivity type (135). Accordingly, a channel region (Ch) may be formed between the first well of the second conductivity type (130) and the second wells of the second conductivity type (135) in the second embodiment. The horizontal width of the channel may correspond to the separation distance between the first well of the second conductivity type (130) and the second wells of the second conductivity type (135).

Meanwhile, in the second embodiment, depletion may occur in the channel direction not only in the second wells of the second conductivity type (135), but also in the first well of the second conductivity type (130).

Accordingly, since PN junctions are formed on both sides of the channel region and depletion occurs, there is a technical effect of easily implementing channel blocking in the off-state MOSFET, thereby preventing leakage current in the channel. In addition, there is a technical effect of controlling the horizontal width of the channel by controlling the horizontal width of the first well of the second conductivity type (130) and the second wells of the second conductivity type (135).

The power semiconductor device according to the embodiment has a technical effect of controlling the thickness or width of the channel.

For example, the embodiment can control the thickness or width of the channel by controlling the thickness or width of the first well of the second conductivity type (130) and the second wells of the second conductivity type (135).

In addition, the embodiment has a technical effect that can improve the electrical performance of the SiC MOFET.

For example, the embodiment can improve the electrical performance by forming the width of the channel wide to reduce the on-state resistance (Ron).

In addition, the embodiment has a technical effect that can prevent leakage current of the channel.

For example, the embodiment forms a PN junction at the upper and lower portions of the channel, and when in the off state, depletions are formed at the upper and lower portions to prevent leakage current of the channel through channel blocking.

Although the present invention has been described above with reference to embodiments thereof, it will be readily understood by those skilled in the art that the present invention can be variously modified and changed within the scope of the invention as set forth in the claims below.

### [Reference signs]

| | | | |
|---|---|---|---|
| [129] Ch: | channel region | 110: | substrate |
| [130] 115: | epi layer of the first conductivity type | 130: | first well of the second conductivity type |
| [131] 135: | second wells of the second conductivity type | 137: | JFET region |
| [132] 138: | CSL region | 140: | well of the first conductivity type |
| [133] 145: | contact region of the second conductivity type | 150: | gate insulating layer |
| [134] 155: | gate 160: interlayer insulating layer | 162: | source electrode |

## Claims

1. A power semiconductor device comprising:
a substrate;
an epi layer of a first conductivity type disposed on the substrate;
a junction field effect transistor (JFET) region disposed on the epi layer of the first conductivity type;
a plurality of second wells of a second conductivity type spaced apart from each other in the JFET region;
a source region of the first conductivity type on the second wells of the second conductivity type;
a gate insulating layer on the source region of the first conductivity type;
a gate on the gate insulating layer; and
a first well of the second conductivity type under the second wells of the second conductivity type,
wherein the JFET region is disposed between the first well of the second conductivity type and the second wells of the second conductivity type.

2. The power semiconductor device according to claim 1, wherein the first well of the second conductivity type is spaced apart from the second wells of the second conductivity type.

3. The power semiconductor device according to any one of claims 1 or 2, wherein a horizontal width of the gate insulating layer is greater than a horizontal width of the first well of the second conductivity type.

4. The power semiconductor device according to any one of claims 1 to 3, wherein the source region of the first conductivity type is in contact with the JFET region.

5. The power semiconductor device according to any one of claims 1 to 4, wherein an upper surface of the first well of the second conductivity type is in contact with the gate insulating layer, and a side surface of the first well of the second conductivity type is in contact with the source region of the first conductivity type.

6. The power semiconductor device according to any one of claims 1 to 5, wherein a thickness of the first well of the second conductivity type is thinner than the thickness of the source region of the first conductivity type.

7. The power semiconductor device according to any one of claims 1 to 6, wherein a top surface of the first well of the second conductivity type is the same as that of the source region of the first conductivity type.

8. The power semiconductor device according to any one of claims 1 to 7, wherein a vertical distance between the first well of the second conductivity type and the second wells of the second conductivity type is greater than that of the first well of the second conductivity type.

9. The power semiconductor device according to claim 8, wherein the vertical distance between the first well of the second conductivity type and the second wells of the second conductivity type is in a range of 1.5 to 3 times of a thickness of the first well of the second conductivity type.

10. The power semiconductor device according to any one of claims 1 to 9, further comprising a contact region of the second conductivity type on the second wells of the second conductivity type, and
wherein the contact region of the second conductivity type is in contact with the second wells of the second conductivity type and the source region of the first conductivity type.

11. The power semiconductor device according to claim 10, wherein in the off state, the first well of the second conductivity type is configured to undergo a depletion in a downward direction, and the second wells of the second conductivity type is configured to undergo a depletion in an upward direction.

12. The power semiconductor device according to any one of claims 1 to 11, wherein a concentration of the first well of the second conductivity type is lower than that of the second wells of the second conductivity type.

13. The power semiconductor device according to any one of claims 1 to 12, wherein the source region of the first conductivity type, the first well of the second conductivity type, and the second wells of the second conductivity type are in contact with each other at the same time.

14. The power semiconductor device according to any one of claims1 to 13, wherein the second wells of the second conductivity type are in contact with the contact region of the second conductivity type, the source region of the first conductivity type, and the JFET region at the same time.

15. A power converter including the power semiconductor device according any one of claims 1 to 14.
